# EUROPEAN PATENT SPECIFICATION

(11) **EP 4 199 079 B1**
(45) Date of publication and mention of the grant of the patent: **19.08.2026**
(21) Application number: 22204068.5
(22) Date of filing: 27.10.2022
(51) Int. Cl.: H10W 20/00, H10W 20/20, H10W 20/41, H10W 20/40, H10W 20/42

(54) **BACKSIDE POWER DELIVERY NETWORK AND SIGNAL ROUTING**
RÜCKSEITIGES STROMVERSORGUNGSNETZWERK UND SIGNALROUTING
RÉSEAU DE DISTRIBUTION D'ÉNERGIE ARRIÈRE ET ROUTAGE DE SIGNAL

(30) Priority: 20.12.2021 US 202117556404
(43) Date of publication of application: 21.06.2023
(73) Proprietor: INTEL Corporation, Santa Clara, CA 95054 (US)
(72) Inventor: Majhi, Prashant, San Jose, 95121 (US); Murthy, Anand, Portland, 97229 (US)
(74) Representative: Goddar, Heinz J.

(56) References cited:
- CN-A- 113 206 037
- US-A1- 2020 294 998
- US-A1- 2021 082 873
- US-B1- 9 331 062

## Description

### FIELD OF THE DISCLOSURE

The present disclosure relates to integrated circuits, and more particularly, to interconnect structures for signal routing and power delivery.

### BACKGROUND

As integrated circuits continue to scale downward in size, a number of challenges arise. For instance, it is becoming increasingly difficult to support high density of scaled frontside interconnects for signal routing and high-power delivery. One approach to circumvent congestion of frontside interconnects due to power and signal routing includes the use of a backside power delivery network (PDN). However, frontside signal routing continues to be congested, especially for highly dense circuits with long routing lengths.

US 9,331,062 B1 discloses integrated circuits with backside power delivery capabilities. An integrated circuit may include a substrate having front and back surfaces, a first interconnect stack formed on the front surface, and a second interconnect stack formed on the back surface. Routing structures that carry data signals, control signals, and other user signals may be formed only in the first interconnect stack. A large majority of routing structures that carry power supply signals may be formed in the second interconnect stack. Decoupling capacitor circuitry such as deep trench capacitors may be formed in the back surface of the substrate. The integrated circuit may be mounted on a package substrate. The first interconnect stack may be coupled to the package substrate via wire bond pads, whereas the second interconnect stack may be coupled to the package substrate via an array of solder bumps.

US 2021/0082873 A1 relates to backside contact for thermal displacement in a multi-wafer stacked integrated circuit. This document discloses a three dimensional integrated circuit (IC) stack, including a first IC die having a first substrate and a first interconnect structure over a frontside of the first substrate; a second IC die having a second substrate and a second interconnect structure over the frontside of the second substrate; and a third IC die vertically between the first and second IC dies and having a third substrate, a third interconnect structure over the frontside of the third substrate, and a third bonding structure over a backside of the third substrate. A heat dissipation path extends from the third substrate to at least the first or second substrate, and includes a backside contact that extends from the third bonding structure to the backside of the third substrate and that is thermally coupled to at least the first or second interconnect structure.

US 2020/0294998 A1 relates to backside contacts for semiconductor devices. Backside contact structures include etch selective materials to facilitate backside contact formation. An integrated circuit structure includes a frontside contact region, a device region below the frontside contact region, and a backside contact region below the device region. The device region includes a transistor. The backside contact region includes a first dielectric material under a source or drain region of the transistor, a second dielectric material laterally adjacent to the first dielectric material and under a gate structure of the transistor. A non-conductive spacer is between the first and second dielectric materials. The first and second dielectric materials are selectively etchable with respect to one another and the spacer. The backside contact region may include an interconnect feature that, for instance, passes through the first dielectric material and contacts a bottom side of the source/drain region, and/or passes through the second dielectric material and contacts the gate structure.

CN 113206037 A discloses a method for forming a semiconductor device and a semiconductor device. In one embodiment, the method for forming the semiconductor device includes forming a first transistor and a second transistor over a first substrate; forming a front side interconnection structure above the first transistor and the second transistor; etching at least one back side of the first substrate to expose the first transistor and the second transistor; forming a first backside through hole electrically connected to the first transistor; forming a second backside through hole electrically connected to the second transistor; depositing a dielectric layer over the first backside through hole and the second backside through hole; forming a first conductive wire in the dielectric layer, the first conductive wire being a power rail electrically connected to the first transistor through hole the first backside via; and forming a second conductive wiring in the dielectric layer, wherein the second conductive wiring is a signal wiring electrically connected to the second transistor through the second backside through hole.

### SUMMARY

The present invention is defined by claim 1. Advantageous embodiments are described by the dependent claims.

### BRIEF DESCRIPTION OF THE DRAWINGS

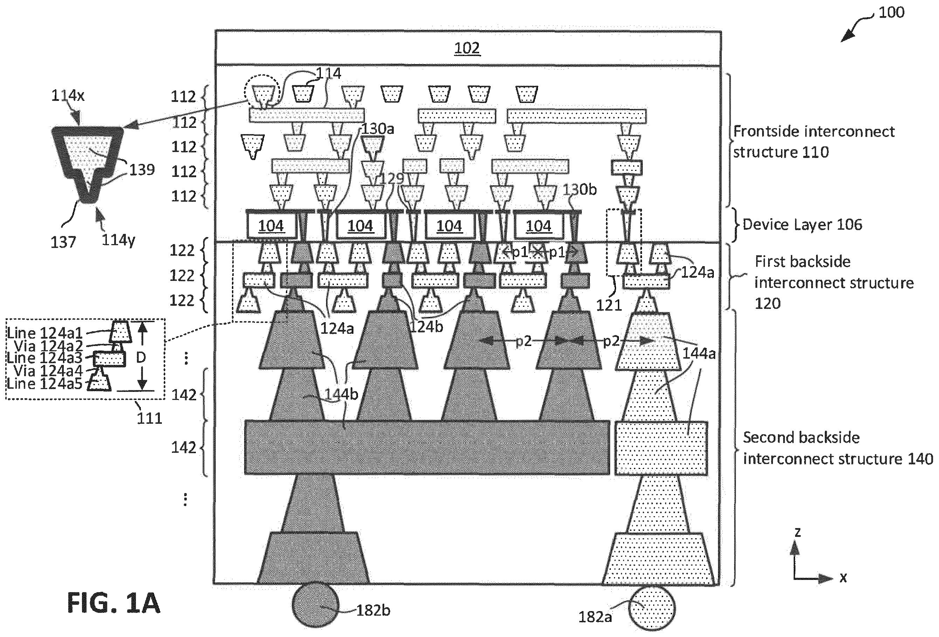

Fig. 1A illustrates a cross-sectional view of a section of an integrated circuit (IC) comprising (i) a device layer including a plurality of active and/or passive devices (such as transistors), wherein one or more interconnect features (e.g., conductive vias) extend vertically through the device layer, (ii) a frontside interconnect structure for intra-chip logic signal routing and inter-chip logic signal routing, (iii) a first backside interconnect structure for intra-chip logic signal routing, inter-chip logic signal routing, and routing power to the active and/or passive devices, and (iv) a second backside interconnect structure for inter-chip logic signal routing and routing power to the active and/or passive devices, in accordance with an embodiment of the present disclosure.

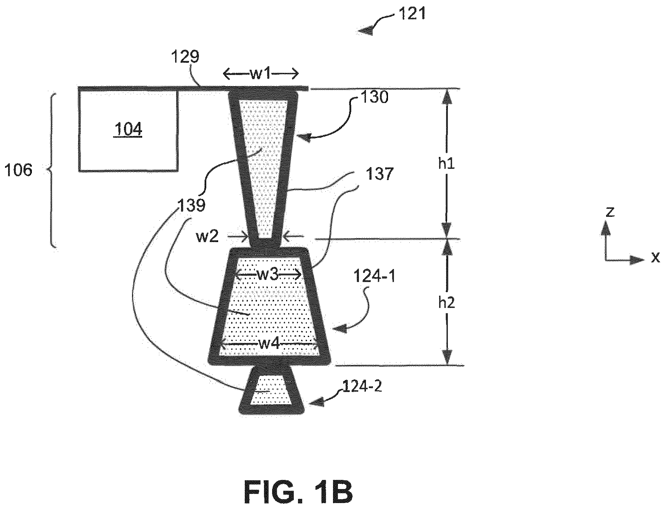

Fig. 1B illustrates a magnified view of a section of the IC of Fig. 1A, in accordance with an embodiment of the present disclosure.

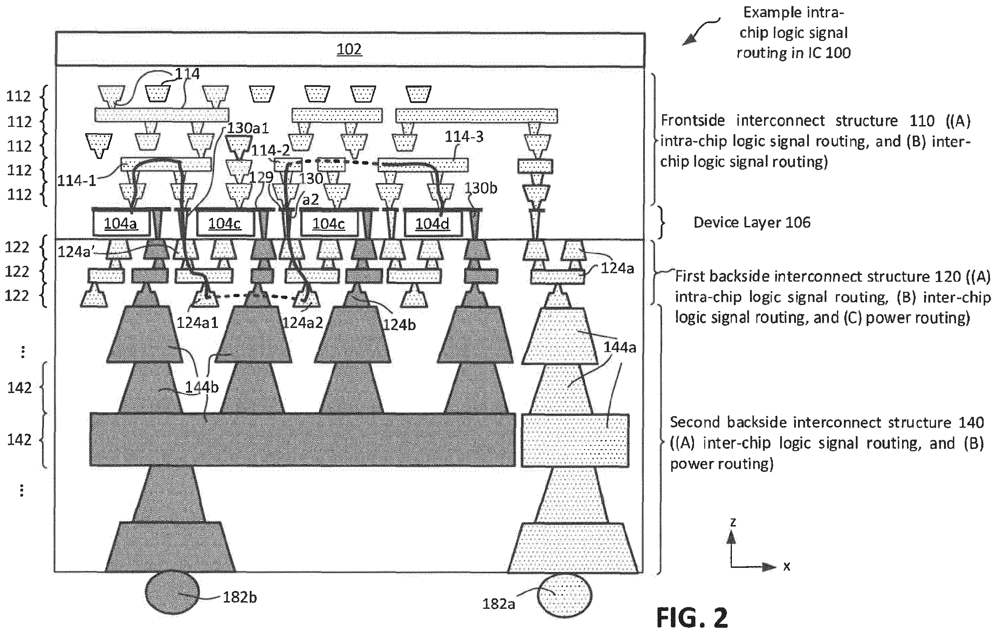

Fig. 2 illustrates an example of intra-chip logic signal routing in the IC of Fig. 1A, using the frontside interconnect structure, an interconnect feature extending through the device layer, and the first backside interconnect structure, in accordance with an embodiment of the present disclosure.

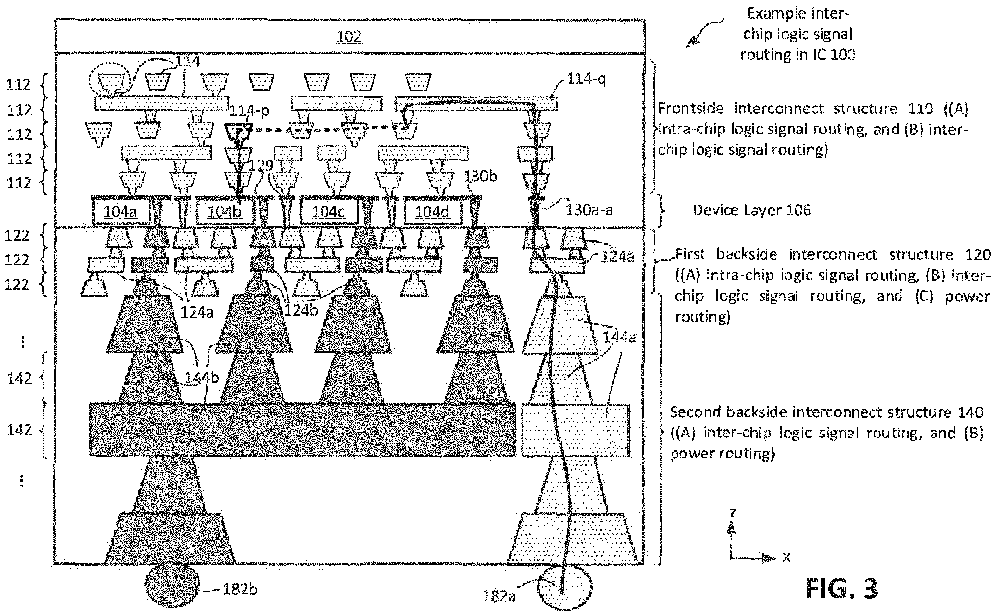

Fig. 3 illustrates an example of inter-chip logic signal routing in the IC of Fig. 1A, using the frontside interconnect structure, an interconnect feature extending through the device layer, the first backside interconnect structure, and the second backside interconnect structure, in accordance with an embodiment of the present disclosure.

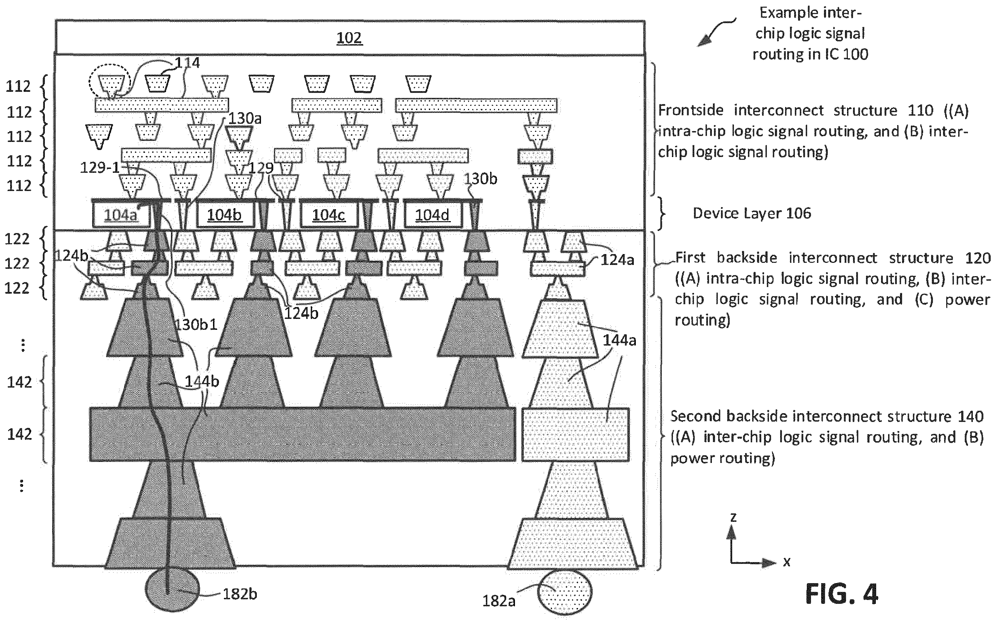

Fig. 4 illustrates an example of power routing, to route power from outside the IC of Fig. 1A to a transistor of the IC, using an interconnect feature extending through the device layer, the first backside interconnect structure, and the second backside interconnect structure, in accordance with an embodiment of the present disclosure.

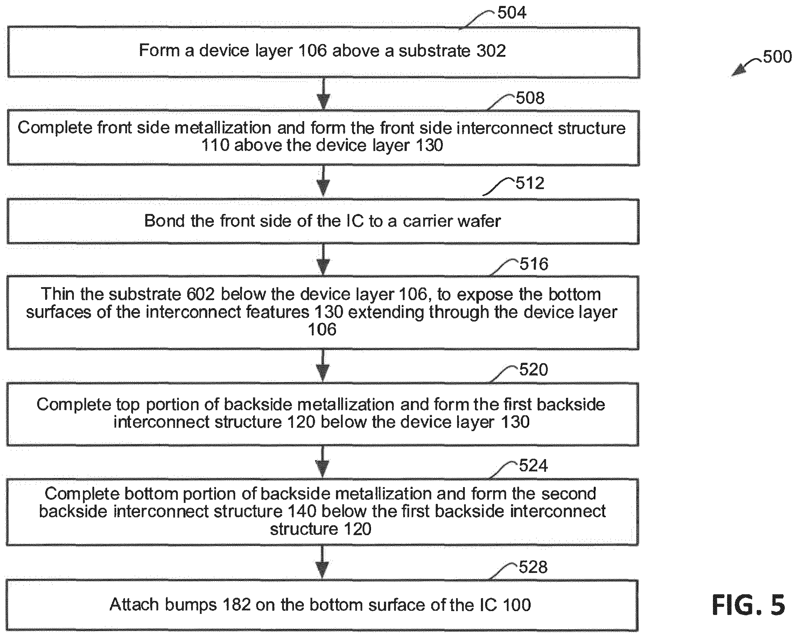

Fig. 5 illustrates a flowchart depicting a method of forming an IC comprising (i) a device layer including a plurality of active and/or passive devices (such as transistors), wherein one or more first interconnect features (e.g., conductive vias) extend vertically through the device layer, (ii) a frontside interconnect structure for intra-chip logic signal routing and inter-chip logic signal routing, (iii) a first backside interconnect structure for intra-chip logic signal routing, inter-chip logic signal routing, and routing power to the active and/or passive devices, and (iv) a second backside interconnect structure for inter-chip logic signal routing and routing power to the active and/or passive devices, in accordance with an embodiment of the present disclosure.

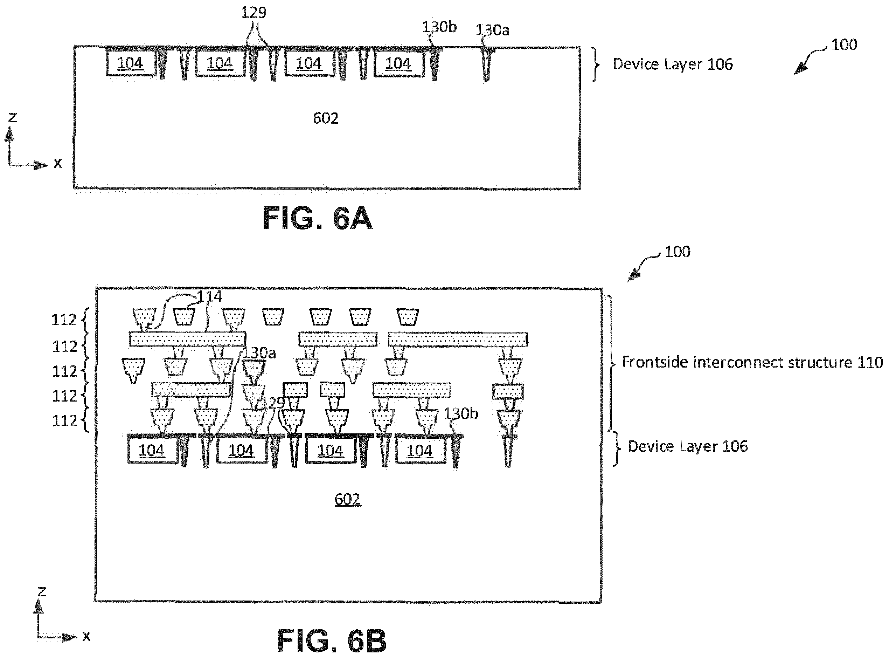

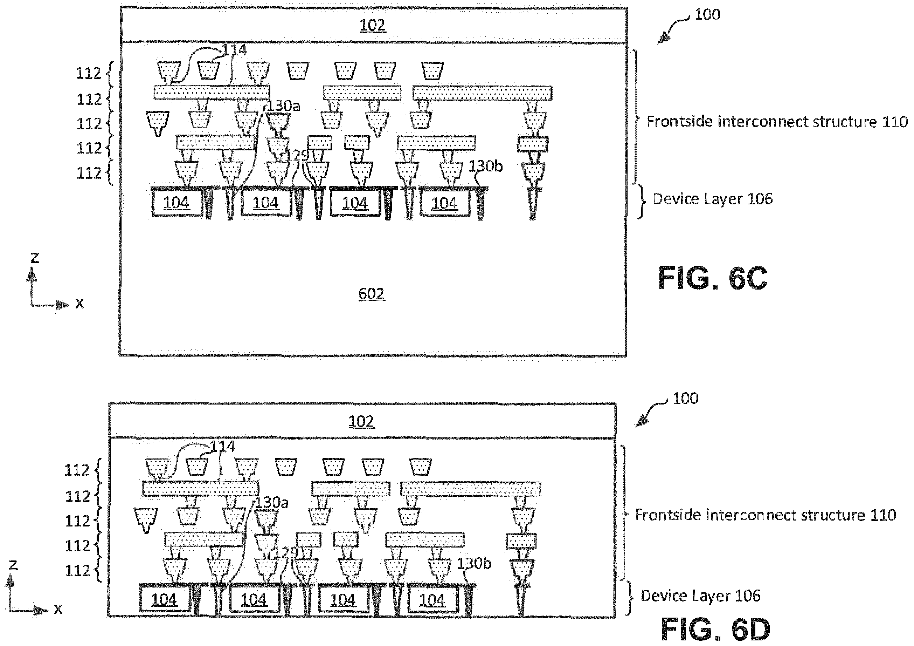

Figs. 6A-6F illustrate cross-sectional views of an IC (such as the IC of Figs. 1A, 1B, and 2) in various stages of processing, in accordance with an embodiment of the present disclosure.

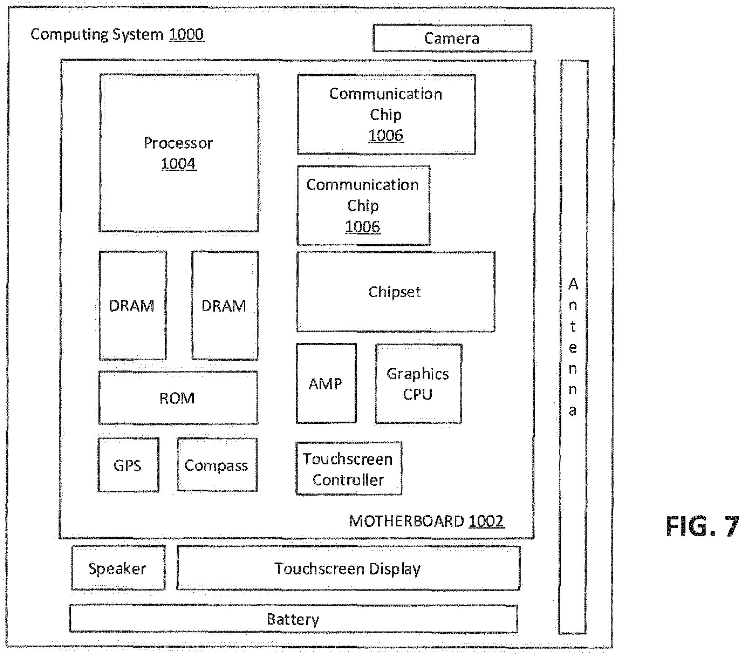

Fig. 7 illustrates a computing system implemented with integrated circuit structures having one or more interconnect features formed using the techniques disclosed herein, in accordance with some embodiments of the present disclosure.

These and other features of the present embodiments will be understood better by reading the following detailed description, taken together with the figures herein described. In the drawings, each identical or nearly identical component that is illustrated in various figures may be represented by a like numeral. For purposes of clarity, not every component may be labeled in every drawing. Furthermore, as will be appreciated, the figures are not necessarily drawn to scale or intended to limit the described embodiments to the specific configurations shown. For instance, while some figures generally indicate straight lines, right angles, and smooth surfaces, an actual implementation of the disclosed techniques may have less than perfect straight lines and right angles (e.g., curved or tapered sidewalls and round corners), and some features may have surface topography or otherwise be non-smooth, given real-world limitations of fabrication processes. Further still, some of the features in the drawings may include a patterned and/or shaded fill, which is merely provided to assist in visually identifying the different features. In short, the figures are provided merely to show example structures.

### DETAILED DESCRIPTION

Provided herein are integrated circuit structures comprising (i) a device layer including a plurality of active and/or passive devices (such as transistors), wherein one or more interconnect features (e.g., conductive vias) extend vertically through the device layer, (ii) a frontside interconnect structure for intra-chip logic signal routing and inter-chip logic signal routing, (iii) a first backside interconnect structure for intra-chip logic signal routing, inter-chip logic signal routing, and routing power to the active and/or passive devices, and (iv) a second backside interconnect structure for inter-chip logic signal routing and routing power to the active and/or passive devices. In one embodiment, an integrated circuit device includes (i) a device layer including a plurality of transistors, (ii) a first interconnect structure above the device layer, (iii) a second interconnect structure below the device layer, and (iv) a plurality of conductive vias extending through the device layer and coupling the first and second interconnect structures. In an example, the first interconnect structure is for (i) routing logic signals between transistors of the plurality of transistors, and (ii) routing logic signals between transistors of the plurality of transistors and first one or more input/output (I/O) pins. In an example, the second interconnect structure is for (i) routing logic signals between transistors of the plurality of transistors, (ii) routing logic signals between transistors of the plurality of transistors and the first one or more I/O pins, and (iii) routing power from second one or more I/O pins to transistors of the plurality of transistors. In an example, the integrated circuit device further includes a third interconnect structure below the second interconnect structure. The third interconnect structure is for (i) routing logic signals between transistors of the plurality of transistors and the first one or more I/O pins, and (ii) routing power from second one or more I/O pins to transistors of the plurality of transistors.

In another embodiment, an integrated circuit includes a device layer including a plurality of transistors, and a first via vertically extending through the device layer and for routing a logic signal from a frontside of the device layer to a backside of the device layer. In an example, the first via is laterally between transistors of the plurality of transistors. In an example, the integrated circuit further includes a second via vertically extending through the device layer and for routing power from the backside of the device layer to a transistor of the device layer. The second via is laterally between transistors of the plurality of transistors. In an example, the integrated circuit further includes a first backside interconnect structure below the device layer and having a first pitch. In an example, the first backside interconnect structure is for routing the logic signal and the power signal, and includes first, second, and third interconnect features. The first via lands on the first interconnect feature and the second via lands on the second interconnect feature, and the third interconnect feature is conductively coupled to the second interconnect feature. In an example, the second backside interconnect structure has a second pitch that is at least 10% greater than the first pitch. In an example, the second backside interconnect structure is for routing the power signal and includes a fourth interconnect feature, where the third interconnect feature lands on the fourth interconnect feature.

In yet another embodiment, an integrated circuit comprises a device layer including a plurality of transistors, at least one of the transistors to generate a logic signal, and the device layer to receive power from a power signal. In an example, the integrated circuit further comprises a first via vertically extending through the device layer and for routing the logic signal from a frontside of the device layer to a backside of the device layer. The first via is laterally between transistors of the plurality of transistors. In an example, the integrated circuit further comprises a second via vertically extending through the device layer and for routing the power signal from the backside of the device layer to the device layer, where the second via is laterally between transistors of the plurality of transistors. In an example, the integrated circuit further comprises a frontside interconnect structure above the device layer and including one or more frontside interconnect layers for routing the logic signal, and a backside interconnect structure below the device layer. In an example, the first backside interconnect structure includes first one or more backside interconnect features for routing the logic signal, and second one or more backside interconnect features for routing the power signal.

In a further embodiment, a method of forming an integrated circuit comprises forming, on a substrate, a device layer comprising a plurality of transistors and a plurality of conductive vias extending through the device layer, and forming a frontside interconnect structure above the device layer and including one or more frontside interconnect layers. In an example, the one or more frontside interconnect layers includes frontside conductive interconnect features. In an example, the method further comprises removing a section of the substrate under the device layer, so as to expose a bottom surface of the plurality of conductive vias. In an example, the method further comprises forming a first backside interconnect structure below the device layer. In an example, the first backside interconnect structure includes first one or more backside interconnect layers, the first one or more backside interconnect layers including a first plurality of backside conductive interconnect features. In an example, a first backside conductive interconnect feature of the first plurality of backside conductive interconnect features conjoins with a corresponding one of the plurality of conductive vias. In an example, the method further comprises forming a second backside interconnect structure below the first backside interconnect structure. In an example, the second backside interconnect structure includes second one or more backside interconnect layers, the second one or more backside interconnect layers including a second plurality of backside conductive interconnect features. In an example, the second backside interconnect structure is for routing power and logic signals between the first backside interconnect structure and a plurality of I/O pins of the integrated circuit. Numerous variations, embodiments, and applications will be apparent in light of the present disclosure.

### General Overview

As previously noted, with increased scaling of microelectronic devices, it is becoming increasingly difficult to support high density of scaled frontside interconnects for logic signal routing, even with use of a backside power delivery network (PDN). The congestion in the frontside signal routing causes increased metal layers resulting in corresponding added cost, and/or high interconnect resistance adversely affecting the performance of the system.

Accordingly, techniques are provided herein to form an IC that uses a frontside interconnect structure for routing intra-chip logic signals and inter-chip logic signals, and two backside interconnect structures: (i) a first backside interconnect structure below the device layer and for routing both intra-chip logic signals and inter-chip logic signals, as well as for backside power delivery to the device layer, and (ii) a second backside interconnect structure below the first backside interconnect structure, where the second backside interconnect structure is used for routing inter-chip logic signals and for backside power delivery to the device layer. The input/output (I/O) pins of the IC chip are coupled to the second backside interconnect structure. As will be discussed in further detail herein, one or more conductive vias through the device layer couples the frontside interconnect structure with the first backside interconnect structure. Because the frontside interconnect structure, as well as the first and second backside interconnect structures, are now used for logic signal and power routing, this reduces logic signal routing task to be handled by the frontside interconnect structure. Accordingly, routing congestion in the frontside interconnect structure is reduced, thereby alleviating the above discussed issues associated with congestion in the frontside interconnect structure.

As the name suggests, routing of intra-chip logic signals (also referred to herein as intra-chip logic signal routing) refers to logic signal routing between various active and/or passive devices of the device layer of the IC. Routing of a logic signal between two transistors of the device layer is an example of such an intra-chip logic signal routing. Thus, for intra-chip logic signal routing, the logic signal remains within the IC and no I/O pin is involved in such routing.

As the name suggests, routing of inter-chip logic signals (also referred to herein as inter-chip logic signal routing) refers to logic signal routing between (i) active and/or passive devices of the device layer and (ii) corresponding I/O pins of the IC. Routing of a logic signal between a transistor of the device layer and a I/O pin is an example of such an inter-chip logic signal routing.

Routing of power (also referred to herein as power routing or as power delivery routing) refers to routing or delivering power from outside the IC to devices within the device layer. Delivery of power from an I/O pin of a transistor of the device layer is an example of such routing of power.

In one embodiment, the IC comprises the device layer including a plurality of active and passive devices, such as transistors, resistors, capacitors, inductors, and/or other types of active or passive devices. The frontside interconnect structure is above the device layer, i.e., on a frontside of the active devices of the device layer. The frontside interconnect structure comprises a plurality of conductive frontside interconnect features, such as conductive lines and vias.

The IC further comprises the first backside interconnect structure below the device layer, i.e., on a backside of the active devices of the device layer. The first backside interconnect structure comprises a corresponding plurality of first backside conductive interconnect features, such as conductive lines and vias.

The IC further comprises the second backside interconnect structure below the first backside interconnect structure, on the backside of the active devices of the device layer. The second backside interconnect structure comprises a corresponding plurality of second backside conductive interconnect features, such as conductive lines and vias.

The IC further comprises a plurality of bumps coupled to the bottom surface of the second backside interconnect structure. The IC transmits and/or receives logic signals and power from outside circuits (such as a printed circuit board (PCB), a package substrate, or an interposer assembly), through the bumps coupled to the second backside interconnect structure. Thus, the IC is accessed through the backside of the IC.

The IC further comprises a plurality of interconnect feature, such as conductive vias, extending through the device layer. For example, one or more of the conductive vias extending through the device layer couple (i) the frontside interconnect structure above the device layer, and (ii) the first backside interconnect structure below the device layer. In one embodiment, one or more conductive vias may be coupled to a front side of corresponding one or more transistors of the device layer, through corresponding one or more conductive conductors within the device layer, e.g., to supply power from the one or more conductive vias to the corresponding one or more transistors.

As discussed, intra-chip logic signal routings are performed through the frontside interconnect structure, one or more of the conductive vias extending through the device layer, and the first backside interconnect structure. For example, for a logic signal to be routed from a first transistor to a second transistor of the device layer, the logic signal is transmitted from a frontside of the first transistor to frontside interconnect features of the frontside interconnect structure, and then through a first conductive via (e.g., extending through the device layer) to backside interconnect features of the first backside interconnect structure. The logic signal is then routed from the backside interconnect features of the first backside interconnect structure, through a second conductive via (e.g., extending through the device layer), to again the frontside interconnect structure. Finally, interconnect features of the frontside interconnect structure routes the logic signal to a frontside of the second transistor. Note that the second backside interconnect structure does not participate in the intra-chip logic signal routing, in an example.

In one embodiment, inter-chip logic signal routings are performed through the frontside interconnect structure, one or more of the conductive vias extending through the device layer, the first backside interconnect structure, and the second backside interconnect structure. For example, for a logic signal to be routed from a first transistor to an I/O pin, the logic signal is transmitted from a frontside of the first transistor to frontside interconnect features of the frontside interconnect structure, and then through a conductive via (e.g., extending through the device layer) to first backside interconnect features of the first backside interconnect structure. The logic signal is then transmitted from the first backside interconnect features of the first backside interconnect structure to second backside interconnect features of the second backside interconnect structure. Finally, the second backside interconnect structure routes the logic signal to a bump attached to the second backside interconnect structure.

In one embodiment, power delivery is performed through the second backside interconnect structure, the first backside interconnect structure, and one or more of the conductive vias extending through the device layer. For example, for a power signal to be routed from an external component of a transistor of the IC, the power signal is transmitted from a bump to interconnect features of the second backside interconnect structure, then to interconnect features of the first backside interconnect structure, and then to a conductive via extending through the device layer. Finally, a conductor within the device layer routes the power from the conductive via to a frontside of the transistor.

To form the above discussed IC, the device layer and the conductive vias extending through the device layer are initially formed over a sacrificial substrate. Subsequently, front side metallization above the device layer is performed, to form the frontside interconnect structure above the device layer. A carrier wafer is then bonded to a top of the resultant IC, i.e., on a front side of the IC. The carrier wafer allows the overall structure to be inverted, to facilitate subsequent backside processing.

Note that the inversion of the overall structure is ignored when using orientation language (such as above and below), such that such orientation language is used consistently for ease of description. That is, for purposes of the orientation language, it is assumed that the overall structure is not inverted.

After bonding of the carrier wafer, the sacrificial substrate below the device layer is thinned, until a bottom section of the conductive vias extending through the device layer is exposed through the bottom surface of the thinned substrate. Then the first backside interconnect structure is formed below the device layer and below the conductive vias. Subsequently, the second backside interconnect structure is formed below the first backside interconnect structure, and bumps are attached below the second backside interconnect structure, to complete the above discussed IC.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. In particular, in some embodiments, such tools may be used to detect a frontside interconnect structure above a device layer, a first backside interconnect structure and the second backside interconnect structure below the device layer, conductive vias extending thorough the device layer, and bumps attached to a bottom surface of the second backside interconnect structure. In some such embodiments, such tools may also be used to detect selective use of the various interconnect structures for inter-chip and inter-chip logic signal routing and power routing, as discussed herein. Numerous configurations and variations will be apparent in light of this disclosure.

### Architecture and Methodology

**Fig. 1A** illustrates a cross-sectional view of a section of an integrated circuit (IC) 100 comprising (i) a device layer 106 including a plurality of active and/or passive devices (such as transistors 104), wherein one or more interconnect features 130 (e.g., conductive vias) extend vertically through the device layer 106, (ii) a frontside interconnect structure 110 for intra-chip logic signal routing and inter-chip logic signal routing, (iii) a first backside interconnect structure 130 for intra-chip logic signal routing, inter-chip logic signal routing, and routing power to the active and/or passive devices, and (iv) a second backside interconnect structure 140 for inter-chip logic signal routing and routing power to the active and/or passive devices, in accordance with an embodiment of the present disclosure.

Referring to Fig. 1A, as illustrated, the device layer 106 includes a plurality of active and/or passive devices, such as transistors 104. The device layer 106 may represent a region that includes active and passive devices, such as transistors, resistors, capacitors, inductors, and/or other types of active or passive devices. In an example, the device layer 106 may include dielectric material, such as interlayer dielectric (ILD), at least in part encapsulating the transistors 104. The device layer 106, in an example, may also include a substrate on which the transistors are formed. Although merely four transistors 104 are illustrated to be included in the device layer 106, the device layer 106 is likely to include a larger number of transistors and may further include other types of active and/or passive devices. For example, in addition to (or instead of) the transistors 104, the device layer 106 may also include one or more other electronic components, such as diodes, resistors, capacitors, inductors.

Individual ones of the transistors 104 can be of any appropriate type, such as a planar or a non-planar transistor, such as a FinFET, a forksheet transistor, a gate all around (GAA) transistor such as a nanoribbon transistor, a nanowire transistor, a nanosheet transistor, or another appropriate type of transistor. In an example, individual transistor 104 may include structures such as channel region, source region, drain region, and gate stack. The transistors 104 are symbolically illustrated in Fig. 1A using a rectangular shape, without illustrating the detailed structure of the transistors.

In the orientation of the IC 100 illustrated in Fig. 1A, a section of the IC 100 above the device layer 106 is referred to herein as a frontside of the device layer 106, and another section of the IC 100 below the device layer 106 is referred to herein as a backside of the of the device layer 106. In an example, the frontside and the backside are respectively the frontside and backside of individual transistors 104.

In one embodiment, the frontside of the IC 100 comprises a plurality of interconnect layers 112 (also referred to herein as "frontside interconnect layers 112") forming an interconnect structure 110 (also referred to herein as "frontside interconnect structure 110"). Individual frontside interconnect layer 112 comprises dielectric material and corresponding one or more conductive frontside interconnect features 114. For example, the interconnect layers 112 comprise various frontside metallization levels. Thus, the interconnect structure 110 on the frontside comprises the plurality of conductive interconnect features 114. The conductive interconnect features 114 are, for example, conductive vias, conductive lines, and/or other suitable types of interconnect features. In an example, these interconnect features 114 are used to (i) route logic signals between various devices (such as transistors 104) in the device layer 106 of the IC 100 (also referred to as intra-chip logic signal routing) and/or (ii) route logic signals between the transistors 140 and external components (also referred to as inter-chip logic signal routing), e.g., using I/O pins below the backside of the IC 100.

In one embodiment, a top portion of the backside of the IC 100 comprises a plurality of interconnect layers 122 (also referred to herein as "first backside interconnect layers 112") forming a first backside interconnect structure 120, and a bottom portion of the backside of the IC 100 comprises another plurality of interconnect layers 142 (also referred to herein as "second backside interconnect layers 112") forming a second backside interconnect structure 140.

Thus, two backside interconnect structures 120, 140 are formed. In an example, functionality of the two backside interconnect structures 120, 140 are different, as will be discussed herein in turn. In an example, the two backside interconnect structures 120, 140 may be combined, to form a single unified backside interconnect structure, functionality of a top portion of which may be different from functionality of a bottom portion.

Individual interconnect layer 122 of the first backside interconnect structure 120 comprise dielectric material and corresponding one or more conductive backside interconnect features 124. For example, the interconnect layers 122 comprise various backside metallization levels. Thus, the interconnect structure 120 on the top portion of the backside comprises the plurality of conductive interconnect features 124. The conductive interconnect features 124 are, for example, conductive vias, conductive lines, and/or other suitable types of interconnect features.

In an example, these interconnect features 124 of the first backside interconnect structure 120 are used to (i) route logic signals between various devices (such as transistors 104) in the device layer 106 of the IC 100 (i.e., intra-chip logic signal routing), (ii) route logic signals between the transistors 140 and external components, through the I/O pins below the backside of the IC 100 (i.e., inter-chip logic signal routing), and (iii) receive power from external power supply (e.g., via the I/O pins) and deliver the power to the transistors 104 (i.e., power routing). The external components may be, for example, a printed circuit board (PCB) such as a mother board, an interposer assembly, or a package substrate, e.g., any external components bonded or coupled to the IC 100.

The interconnect structure 120 comprises two categories of conductive interconnect features 124: (i) conductive interconnect features 124a illustrated using dotted area, which are used for logic signal routing, and (ii) conductive interconnect features 124b illustrated using grey/darkened area, which are used for power routing, as will be discussed in further detail herein in turn. In an example, although the structure of the interconnect features 124a, 124b may be the same (e.g., similar pitch, similar dimensions), the interconnect features 124a and 124b may have different interconnect routings and may be functionally different.

Individual interconnect layer 142 of the second backside interconnect structure 140 comprise dielectric material and corresponding one or more conductive backside interconnect features 144. For example, the interconnect layers 142 comprise various backside metallization levels. Thus, the interconnect structure 140 on the bottom portion of the backside comprises the plurality of conductive interconnect features 144. The conductive interconnect features 144 are, for example, conductive vias, conductive lines, and/or other suitable types of interconnect features. In an example, these interconnect features 144 are used to (i) route logic signals between the transistors 140 and external components, through I/O pins below the backside of the IC 100 (i.e., intra-chip logic signal routing), and (ii) receive power from external power supply (e.g., via the I/O pins) and deliver the power to the transistors 104 (i.e., power routing). The interconnect structure 140 comprises two categories of conductive interconnect features 144: (i) conductive interconnect features 144a illustrated using dotted areas, which are used for logic signal routing, and (ii) conductive interconnect features 144b illustrated using grey/darkened sections, which are used for power routing, as will be discussed in further detail herein in turn. In an example, although the structure of the interconnect features 144a, 144b may be the same (e.g., similar pitch, similar dimensions), the interconnect features 144a and 144b may have different interconnect routings and may be functionally different.

In one embodiment, the interconnect features 144 of the second backside interconnect structure 140 may have greater dimensions and/or a higher pitch, compared to the interconnect features 124 of the first backside interconnect structure 120. For example, Fig. 1A illustrates a pitch p1 of interconnect features 124 within an interconnect layer 122 of the first backside interconnect structure, and a pitch p2 of interconnect features 144 within an interconnect layer 142 of the second backside interconnect structure. Here, pitch is referred to as a horizontal distance between a middle section of an interconnect feature and a middle section of an adjacent interconnect feature within the same interconnect layer. In one embodiment, the pitch p2 is at least 10% greater, or at least 15% greater, or at least 25% greater, or at least 50% greater, or at least 75% greater, or at least 100% greater than the pitch p1. Thus, in an example, the pitch p2 can be at least twice the pitch p1.

In one embodiment, the IC 100 comprises a plurality of interconnect features 130 vertically extending through the device layer 106 and landing on corresponding interconnect features of the first backside interconnect structure 120. The interconnect features 130 are also referred to herein as intermediate interconnect features 130, as the interconnect features 130 are in intermediate positions or between the frontside interconnect features 114 and backside interconnect features 124, 144.

In an example, the interconnect features 130 extending through the device layer 106 are used to (i) route logic signals between various devices (such as transistors 104) in the device layer 106 of the IC 100 (i.e., intra-chip logic signal routing), (ii) route logic signals between the transistors 140 and external components, through the I/O pins below the backside of the IC 100 (i.e., inter-chip logic signal routing), and (iii) receive power from external power supply (e.g., via the I/O pins) and deliver the power to the transistors 104 (i.e., power routing). Two categories of interconnect features 130 are illustrated: (i) interconnect features 130a illustrated using dotted section, which are used to route logic signals, and (ii) interconnect features 130b illustrated using grey/darkened section, which are used to route power signals.

In an example, the interconnect features 130 are conductive vias extending through the semiconductor and/or dielectric material of the device layer 106. In an example, one or more interconnect features 130 are through silicon vias (TSVs). As illustrated, individual interconnect features 130 may be laterally between two corresponding transistors 140 of the device layer 106.

In an example, one or more of the interconnect features 130 are conductive vias through the device layer 106, and connects the first backside interconnect structure 120 to the transistors 104 and/or the frontside interconnect structure 110. In an example, one or more other interconnect features 130 are buried or backside power rails (BPRs) to supply power to one or more of the transistors 104. In another example, one or more other interconnect features 130 land of BPRs (e.g., one of the interconnect features 124 is a BPR in such an example), to supply power from the BPRs to one or more of the transistors 104.

In one embodiment, the device layer 106 also comprises a plurality of conductors 129. In an example, one or more interconnect feature 130 are coupled to the interconnect structure 110 through corresponding one or more of the conductors 129. In an example, one or more other interconnect feature 129 are coupled to corresponding one or more transistors 104 through corresponding one or more of the conductors 129.

As discussed herein previously, the conductive interconnect features 124 comprises two categories: (i) conductive interconnect features 124a illustrated using dotted sections, and (ii) conductive interconnect features 124b illustrated using grey/darkened sections. Similarly, the conductive interconnect features 144 comprises two categories: (i) conductive interconnect features 144a illustrated using dotted sections, and (ii) conductive interconnect features 144b illustrated using grey/darkened sections. Similarly, two categories of interconnect features 130 are illustrated: interconnect features 130a illustrated using dotted section, and interconnect features 130b illustrated using grey/darkened section. In an example, conductive interconnect features 124a, conductive interconnect features 144a, and conductive interconnect features 130a, each of which are illustrated using dotted sections, are used for logic signal routing (e.g., and not used for routing power to the devices 104). For example, while some of these conductive interconnect features may be used to route logic signals between the devices 104 (i.e., intra-chip logic signal routing), remaining of these conductive interconnect features may be used to route logic signals between the transistors 140 and external components through the I/O pins below the backside of the IC 100 (i.e., inter-chip logic signal routing), e.g., as will be discussed in further detail with respect to Figs. 2 and 3.

In an example, conductive interconnect features 124b and conductive interconnect features 130b, each of which are illustrated using greyed out sections, are used for routing power to the devices 104 (e.g., not used for logic signal routing). For example, these conductive interconnect features may be used to route power, which are received from external components through the I/O pins below the backside of the IC 100, to the various devices 104, e.g., as will be discussed in further detail with respect to Fig. 4.

In an example, the IC 100 is accessed by outside circuits (such as a PCB, an interposer assembly, a package substrate) from the backside. For example, the IC 100 comprises a substrate 102, which also acts as a carrier wafer during formation of the IC 100. For the orientation illustrated in Fig. 1A, the substrate 102 is on a top section of the IC 100. For example, the substrate 102 is above and bonded to the frontside interconnect structure 110. As illustrated, in an example, the frontside interconnect structure 110 may not extend through the substrate 102. Accordingly, in such an example, the IC 100 is accessed by outside circuits from the backside. However, in another example, one or more interconnect features 114 of the frontside interconnect structure 110 may extend through the substrate 102, and the IC 100 may be accessed by outside circuits from the frontside 115 as well.

In the example where the IC 100 is accessed by outside circuits through a bottom surface of the backside, the IC 100 comprises bumps 182, to couple the IC 100 to output circuits, through a package substrate, a PCB, an interposer, or another appropriate component. Two categories of bumps 182 are illustrated: bumps 182a illustrated using dotted section, and bumps 182b illustrated using grey/darkened section. The bumps 182a communicate logic signals between the IC 100 and the external components, and the bumps 182b supply power to the IC 100 for the devices 104.

Fig. 1A illustrates a magnified view of a section 111 of the first backside interconnect structure 120 of the IC 100. The section 111 of the first backside interconnect structure 120 of the IC 100 comprises a plurality of conductive interconnect features 124a1, 124a2, 124a3, 124a4, and 124a5. As illustrated, the interconnect features 124a1, 124a3, and 124a5 are conductive lines, and the interconnect features 124a2 and 124a4 are conductive vias. In an example, the interconnect features 124a1 and 124a5 are horizontal conductive lines traversing into or out of the plane of the paper in which the figure is drawn. In an example, the interconnect feature 124a3 is a horizontal conductive line on the plane of the paper, traversing from left to right. The interconnect features 124a2 and 124a4 are vertical conductive vias, where each via couple two corresponding conductive lines.

Note that while Fig. 1A illustrates a two-dimensional (2D) representation of the interconnect structures 110, 120, 140, these interconnect structures span in the three dimensions. In an example, in a first interconnect layer (such as any of the layers 112, 122, 142), multiple parallel or near parallel conductive lines (e.g., line 124a1) are traversing into and out of the plane of the paper in a horizontal direction. In a second interconnect layer above or below the first interconnect layer, multiple parallel or near parallel conductive lines (e.g., line 124a3) are traversing on the plane of the paper, from left to right, also in the horizontal direction.

A third interconnect layer between the first and second interconnect layers comprises conductive vias (e.g., via 124a2) coupling a line in the first interconnect layer to a corresponding line in the second interconnect layer. Thus, for example, a vertical conductive via of any of the interconnect structures 110, 120, and 140 couples two corresponding conductive lines: (i) one conductive line is traversing into and out of the plane of the paper, and (ii) another conductive line is on the plane of the paper, traversing from left to right. Thus, in the plan or top view (not illustrated in Fig. 1A), the two conductive lines would appear as a "+" shape, with the via located at a junction of the two conductive lines.

Left top side of Fig. 1A illustrates a magnified view of two interconnect features 114x and 114y on the frontside of the IC 100. The interconnect feature 114x is a conductive line traversing into or out of the plane of the paper in which the figure is drawn. The interconnect feature 114y is a conductive via coupling the conductive line 114x to another line. As illustrated, each of the interconnect features 114x, 114y comprises conductive material 139 within a recess, where the recess is within dielectric material of the corresponding interconnect layer 112. A barrier layer 137 is on walls of the interconnect features 114x, 114y. Thus, each of the conductive interconnect features 114x, 114y comprises the conducive material 139, and the barrier layer 137 that separates the conductive material 139 of the interconnect feature from adjacent dielectric material of the corresponding interconnect layer 112.

In an example, no barrier layer may be present between the conductive materials of the interconnect features 114x and 114y, as illustrated in Fig. 1A (e.g., when the interconnect features 114x and 114y are formed using a dual damascene process). In another example and contrary to the illustrations of Fig. 1A, the barrier layer 137 may be present between the conductive materials of the interconnect features 114x and 114y.

In an example, the conductive material 139 within interconnect features 114, 124 tends to diffuse through the adjacent dielectric material of the corresponding interconnect layer. In an example where the conductive material 139 is copper, the diffusion may result in formation of undesirable copper oxide. The barrier layer 137, in an example, prevents diffusion of the conductive material 139 to adjacent dielectric material of the interconnect layer 112. Furthermore, the barrier layer 137 facilitates better adhesion of the conductive material 139 on walls of the interconnect feature 114. Note that in an example, the barrier layer 137 here is representative of a barrier layer, as well as a liner layer, a capping layer, and/or an encapsulation layer that may be present between conductive material of an interconnect feature and adjacent dielectric material.

In an example, the barrier layer 137 has a thickness in the range of 1 to 5 nanometers (nm), or 1 to 10 nm, or 0.5 to 20 nm, or 3 to 20 nm. In an example, the barrier layer 137 has a thickness of at least 1 nm, or at least 3 nm, or at least 5 nm, or at least 7 nm. In an example, the barrier layer 137 has a thickness of at most 5 nm, or at most 10 nm, or at most 20 nm, or at most 30 nm.

Suitable materials for the barrier layer 137 include barrier layer refractory metals and alloys, cobalt, cobalt-nickel (CoNi), ruthenium-cobalt combination, molybdenum, nickel, manganese, titanium-tungsten (Ti ), tantalum (Ta), tantalum-nitride (TaN), tantalum-silicon-nitride (TaSiN), titanium-nitride (TiN), titanium-silicon-nitride (TiSiN), tungsten (XV), tungsten-nitride (WN), tungsten-silicon-nitride (WiSiN), and/or combinations of such materials (e.g., a multi-lay stack of Ta/TaN). In an example, the conductive material 139 comprises suitable conductive materials such as pure copper, ruthenium, molybdenum, tungsten, aluminum, an alloy such as copper-tin (CuSn), copper indium (CuIn), copper-antimony (CuSb), copper-bismuth (CuBi), copper-rhenium (CuRe), and/or any other suitable conductive material.

**Fig. 1B** illustrates a magnified view of a section 121 of the IC 100 of Fig. 1A, in accordance with an embodiment of the present disclosure. For example, section 121 includes an example interconnect feature 130 extending through the device layer 106, and two example interconnect features 124-1 and 124-2 of the first backside interconnect structure 120.

As illustrated in Figs. 1A and 1B, one or more of the interconnect features 114 of the frontside interconnect structure 110 and one or more of the interconnect features 130 extending through the device layer 106 are tapered towards the bottom. For example, Fig. 1B illustrates the interconnect feature 130 having a width w1 at or near a top section of the interconnect feature 130a, and a width w2 at or near a bottom section of the interconnect feature 130a. The widths w1 and w2 are measured in a horizontal direction that is perpendicular to a vertical direction of an imaginary line passing through the interconnect features 130 and 124-1, 124-2. The widths w1 and w2 are measured in a horizontal direction that is parallel to a plane of the device layer 106. Because the interconnect feature 130 is tapered towards the bottom, the width w1 is greater than the width w2. For example, as will be discussed with respect to Figs. 5 and 6A-6B, the recesses for the interconnect features 114 and 130 are formed from the top side of the IC 100, and hence, individual ones of the interconnect features 114 and 130 (e.g., interconnect feature 130 of Fig. 1B) are tapered towards the bottom, e.g., due to unintended technical limitations in forming these recesses using an etching process. The extent of tapering may depend on the etch technology used to form a recess for the corresponding interconnect feature. In an example, in Fig. 1B, width w1 is greater than width w2 by at least 1%, or by at least 2%, or by at least 5%, or by at least 10%, or by at least 15%.

In an example, the width w1 is at least 5 nm, or at least 10 nm, or at least 15 nm, and/or is at most 8 nm, or at most 12 nm, or at most 15 nm, or at most 20 nm, or at most 25 nm, or at most 30 nm, or at most 35 nm. Merely as an example, the width w1 is in the range of 10-30 nm. In an example, the width w2 is at least 5 nm, or at least 10 nm, or at least 15 nm, and/or is at most 8 nm, or at most 12 nm, or at most 15 nm, or at most 20 nm, or at most 25 nm, or at most 30 nm, or at most 35 nm. Merely as an example, the width w2 is in the range of 5-25 nm. In an example, a height h1 of the interconnect feature 130 is in the range of 50-200 nm.

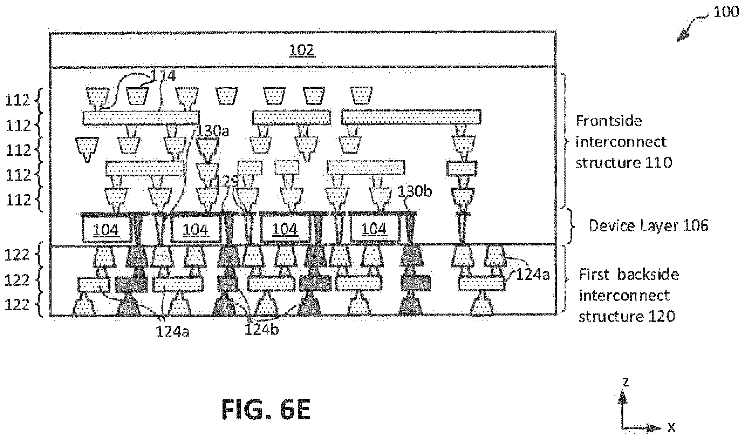

As illustrated in Figs. 1A and 1B, one or more of the backside interconnect features 124, 144 of the backside interconnect structures 120, 140, respectively, are tapered towards the top. For example, Fig. 1B illustrates the interconnect feature 124-1 having a width w3 at or near a top section of the interconnect feature 124-1, and a width w4 at or near a bottom section of the interconnect feature 124-1. The widths w3 and w4 are measured in a horizontal direction that is perpendicular to a vertical imaginary line passing through both the interconnect features 130 and 124-1. The widths w3 and w4 are measured in a horizontal direction that is parallel to a plane of the device layer 106. Because the interconnect feature 124-1 is tapered towards the top, the width w3 is less than the width w4. For example, as will be discussed with respect to Figs. 5 and 6E-6F, the recess for the interconnect feature 124-1 is formed from the bottom or backside of the IC 100, and hence, the interconnect feature 124-1 is tapered towards the top, e.g., due to unintended technical limitations in forming these recesses using an etching process. The extent of tapering may depend on the etch technology used to form a recess for the interconnect feature 124-1. In an example, width w3 is less than width w4 by at least 1%, or by at least 2%, or by at least 5%, or by at least 10%, or by at least 15%.

In an example, the width w3 is in the range of 12-45 nm. In an example, the width w4 is in the range of 15-50 nm. In an example, a height h2 of the interconnect feature 124-1 is in the range of 25-100 nm.

**Fig. 2** illustrates an example of intra-chip logic signal routing in the IC 100 of Fig. 1A, using the frontside interconnect structure 110, the interconnect feature 130 extending through the device layer 106, and the first backside interconnect structure 120, in accordance with an embodiment of the present disclosure. In Fig. 2, the four example transistors 104 are labelled as 104a, 104b, 104c, and 104d. In the example of Fig. 2, the intra-chip logic signal routing is between transistors 104a and 104d. Note that the routing illustrated in Fig. 2 is merely an example, and in an implementation of the IC 100, many such logic signal routing between different devices of the device layer are done through the corresponding interconnect features.

As illustrated, the logic signal is routed between the transistors 104a and 104d through a plurality of interconnect features of the IC 100. Note that the route of the logic signal is illustrated using a combination of solid and dotted sections. The solid sections of the route are through interconnect features that are visible in the 2D plane of Fig. 2. The dotted sections of the route are through interconnect features that are not visible in the 2D plane of Fig. 2, e.g., through interconnect features that are either above or below the plane of the paper on which the figure is drawn.

Following the signal route from the transistor 104a to the transistor 104d, the logic signal transmits upward, from the frontside of the transistor 104a, through a plurality of interconnect features 114, until it reaches a specific interconnect feature 114-1 of the frontside interconnect structure 120. Then the logic signal transmits downwards, through the vertical interconnect feature 130a1, to the first backside interconnect structure 120. For example, the vertical interconnect feature 130a1 is a conductive via through the device layer 106, and lands on an interconnect feature 124a' of the first backside interconnect structure 120. The logic signal is routed from the interconnect feature 130a1 to the interconnect feature 124a', and then to an interconnect feature 124a1, as illustrated in Fig. 2. Thus, the logic signal is transmitted through the frontside interconnect structure 110 and the interconnect feature 130, until it reaches the first backside interconnect structure 120. As illustrated, the logic signal continues going downwards through the first backside interconnect structure 120, until it reaches the interconnect feature 124a1. Interconnect features transmitting the logic signal between the transistor 104a and the interconnect feature 124a1 are visible in the 2D plane of Fig. 2, and hence, this section of the route is illustrated using solid line.

From interconnect feature 124a1, the logic signal is routed to another interconnect feature 124a2 of the first backside interconnect structure 120, through one or more interconnect features (e.g., of the first backside interconnect structure 120) that are not visible in the 2D plane of Fig. 2, e.g., are routed through interconnect features that are either above or below the plane of the paper on which the figure is drawn. Accordingly, this section of the route is illustrated using a dotted line.

From the interconnect feature 124a2, the logic signal is routed upwards, thorough a vertical interconnect feature 130a2 (e.g., which is a conductive via extending through the device layer 106), until it reaches an interconnect feature 114-2 of the frontside interconnect structure 110, as illustrated using a solid line in Fig. 2.

From interconnect feature 11402, the logic signal is routed to another interconnect feature 114-3, through one or more interconnect features (e.g., of the frontside interconnect structure 110), which are not visible in the 2D plane of Fig. 2, e.g., are routed through interconnect features that are either above or below the plane of the paper on which the figure is drawn. Accordingly, this section of the route is illustrated using a dotted line. From the interconnect feature 114-3, the logic signal is routed downwards, through interconnect features 114 of the frontside interconnect structure 110, until it reaches the frontside of the transistor 104d, as illustrating using a solid line in Fig. 2.

Thus, Fig. 2 illustrates an example intra-chip logic signal route for communication of logic signals between a pair of transistors 104, using the frontside interconnect structure 110, the interconnect features 130 extending through the device layer 106, and the first backside interconnect structure 120. It may be noted that the second backside interconnect structure 140 does not participate in any intra-chip logic signal routing, as also illustrated in Fig. 2.

**Fig. 3** illustrates an example of inter-chip logic signal routing in the IC 100 of Fig. 1A, using the frontside interconnect structure 110, the interconnect feature 130 extending through the device layer 106, the first backside interconnect structure 120, and the second backside interconnect structure 140, in accordance with an embodiment of the present disclosure. As discussed herein, inter-chip logic signal routing refers to communication between the active devices of the device layer 106 and one or more external components of the IC 100, e.g., through the solder bumps 182. Note that the routing illustrated in Fig. 3 is merely an example, and in an implementation of the IC 100, many such logic signal routing are done through the corresponding interconnect features.

As illustrated, the logic signal is routed between an example transistor 104b and a circuit external to the IC 100, though the bump 182a and a plurality of interconnect features of the IC 100. Note that the route of the logic signal is illustrated using a combination of solid and dotted sections. The solid sections of the route are through interconnect features that are visible in the 2D plane of Fig. 3. The dotted section of the route is through interconnect features that are not visible in the 2D plane of Fig. 3, e.g., through interconnect features that are either above or below the plane of the paper on which the figure is drawn.

Following the path from the transistor 104b to the bump 182a, the logic signal transmits upward from the frontside of the transistor 104b, through a plurality of interconnect features 114, until it reaches a specific interconnect feature 114-p of the frontside interconnect structure 110.

From interconnect feature 114-p, the logic signal is routed to another interconnect feature 114-q through one or more interconnect features of the frontside interconnect structure 110, which are not visible in the 2D plane of Fig. 2, e.g., are routed through interconnect features that are either above or below the plane of the paper on which the figure is drawn. Accordingly, this section of the route is illustrated using a dotted line.

Then the logic signal transmits downwards, through the vertical interconnect feature 130a-a (e.g., which is a conductive via), to the first backside interconnect structure 120. Thus, the logic signal is transmitted through the frontside interconnect structure 110 and the interconnect feature 130, until it reaches the first backside interconnect structure 120. As illustrated, the logic signal continues going downwards through the interconnect feature 124a of the first backside interconnect structure 120, and then through the interconnect feature 144a of the second backside interconnect structure 140, until it reaches the bump 182a.

Thus, Fig. 3 illustrates an example inter-chip logic signal route for communication of logic signals between an example transistors 104b and the bump 182a, using the frontside interconnect structure 110, the interconnect features 130 extending through the device layer 106, the first backside interconnect structure 120, and the second backside interconnect structure 140. Thus, all three interconnect structures 110, 120, 140 and the interconnect feature 130 participate in the inter-chip logic signal routing, as illustrated in Fig. 3.

**Fig. 4** illustrates an example of power routing, to route a power signal from outside the IC 100 of Fig. 1A to an example transistor 104a of the IC 100, using the interconnect feature 130 extending through the device layer 106, the first backside interconnect structure 120, and the second backside interconnect structure 140, in accordance with an embodiment of the present disclosure. Note that the routing illustrated in Fig. 4 is merely an example, and in an implementation of the IC 100, many such power routing are done through the corresponding interconnect features to various active and/or passive devices of the device layer 106.

As illustrated, the power is received at the bump 182b, which then traverses upwards through the interconnect features 144b of the second backside interconnect structure 140, and then through the interconnect features 124b of the first backside interconnect structure 120, and then through the vertical interconnect feature 130b1. The power is transmitted from the vertical interconnect feature 130b1 to the transistor 104a through the conductor 129-1 within the device layer.

Thus, Fig. 4 illustrates an example power route for transmission of power to the example transistor 104a, using the interconnect features 130 extending through the device layer 106, the first backside interconnect structure 120, and the second backside interconnect structure 140. Thus, the backside interconnect structures 120, 140 and the interconnect feature 130, but not the frontside interconnect structure 110, participate in the inter-chip power signal routing, as illustrated in Fig. 4.

Thus, referring to Figs. 2, 3, and 4, intra-chip logic signal routing is performed through the frontside interconnect structure 110, the interconnect features 130 extending through the device layer 106, and the first backside interconnect structure 120, but not the second backside interconnect structure 140. The inter-chip logic signal routing is performed through the frontside interconnect structure 110, the interconnect features 130 extending through the device layer 106, the first backside interconnect structure 120, and the second backside interconnect structure 140. Finally, power routing is performed through the interconnect features 130 extending through the device layer 106, the first backside interconnect structure 120, and the second backside interconnect structure 140, but not the frontside interconnect structure 110.

Thus, the frontside interconnect structure 110 participates only in inter-chip and intra-chip logic signal routing, but not power routing. The first backside interconnect structure 120 participates in inter-chip and intra-chip signal routing, and also power routing. The second backside interconnect structure 140 participates in inter-chip signal routing and also power routing, but not intra-chip signal routing. Finally, the interconnect features 130 extending through the device layer 130 participates in all types of logic signal and power routing.

**Fig. 5** illustrates a flowchart depicting a method 500 of forming an IC (such as the IC 100 of Figs. 1A-4) comprising (i) a device layer including a plurality of active and/or passive devices (such as transistors), wherein one or more first interconnect features extend vertically through the device layer, (ii) a frontside interconnect structure for intra-chip logic signal routing and inter-chip logic signal routing, (iii) a first backside interconnect structure for intra-chip logic signal routing, inter-chip logic signal routing, and routing power to the active and/or passive devices, and (iv) a second backside interconnect structure for inter-chip logic signal routing and routing power to the active and/or passive devices, in accordance with an embodiment of the present disclosure. **Figs. 6A-6F** illustrate cross-sectional views of an IC (such as the IC 100 of Figs. 1A, 1B, and 2) in various stages of processing, in accordance with an embodiment of the present disclosure. Figs. 5 and 6A-6F will be discussed in unison.

Referring to Fig. 5, the method 200 includes, at 504, forming a device layer 106 above a substrate 602. In an example, a plurality of interconnect features 130 vertically extend through the device layer 106. Fig. 6A illustrates the substrate 602, and the device layer 106 above the substrate 602, where the device layer 106 comprises active and/or passive devices, such as transistors 104. The interconnect features 130a, 130b extend vertically through dielectric material and/or semiconductor material of the device layer 106. Note that the interconnect features 130a and interconnect features 130b are structurally the same - however, they are denoted using different labels (and illustrated using different shadings in the figures) due to their functional differences. For example, as discussed herein, interconnect features 130a are for routing logic signals (e.g., intra-chip logic signal routing and/or inter-chip logic signal routing), whereas interconnect features 130b are for routing power to the transistors 104.

Referring again to Fig. 5, the method 500 then proceeds from 504 to 508, where frontside metallization is completed, to form the frontside interconnect structure 110 above the device layer 106 and on the frontside of the IC 100. For example, Fig. 6B illustrates the interconnect structure 110 formed above the device layer 106, where the interconnect structure 110 comprise interconnect layers 112, and where individual interconnect layer 112 comprises dielectric material and conductive interconnect features 114 within the dielectric material, as discussed with respect to Fig. 1A. The interconnect structure 110 may be formed using any suitable technique for forming such interconnect structures. This completes the frontside metallization of the IC 100.

Referring again to Fig. 5, the method 500 proceeds from 508 to 512, where the frontside of the IC 100 is bonded to a carrier wafer 102. Fig. 6C illustrates a top or frontside of the IC 100 bonded to the carrier wafer 102. The carrier wafer 102 allows the overall structure to be inverted, to facilitate subsequent backside processing. Note that such inversion is not depicted, so as to allow orientation language (such as above and below) to be used consistently for ease of description.

Referring again to Fig. 5, the method 500 proceeds from 512 to 516, where a sacrificial section of the substrate 602 below the device layer 106 is thinned and removed, to expose bottom surfaces of the interconnect features 130 extending vertically through the device layer 106. Any etching technique, such as an isotropic etching technique, may be used or the thinning process. In an example, the etch may be time based, such that the etching process is performed for a preconfigured amount of time until the bottom surfaces of the interconnect features 130 are exposed. In an example, over-etching may be performed, such that a small portion of bottom portions of the interconnect features 130 (as well as a section of the device layer 106) may also be etched. In another example and although not illustrated in the figures, an etch stop layer may be present on the bottom surface of the device layer, which may act to stop the etching process.

Referring again to Fig. 5, the method 500 proceeds from 516 to 520, where top portion of backside metallization is completed, to form the first backside interconnect structure 120 below the device layer 130 and on the backside of the IC 100. Fig. 6E illustrate the first backside interconnect structure 120 below the device layer 130. For example, a first interconnect layer 122 is formed, the first interconnect layer 122 comprising interconnect features 124, such that a top surface of an interconnect feature 124 contacts a bottom surface of a corresponding interconnect feature 130, e.g., as illustrated in Fig. 1B. Then a next level interconnect layer 122 is formed. This process continues, until the first backside interconnect structure 120 is complete, as illustrated in Fig, 6E.

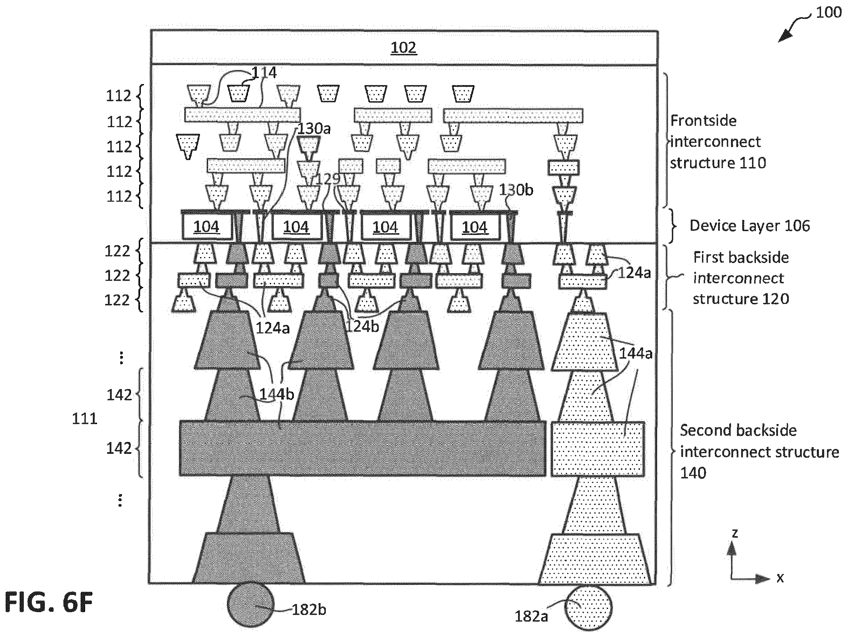

Referring again to Fig. 5, the method 500 proceeds from 520 to 524, where bottom portion of backside metallization is completed, to form the second backside interconnect structure 140 below the first backside interconnect structure 120. Fig. 6F illustrate the second backside interconnect structure 140 below the first backside interconnect structure 120. The second backside interconnect structure 140 is formed using an appropriate technique to form an interconnect structure.

Referring again to Fig. 5, the method 500 proceeds from 520 to 524, where solder bumps 182 are attached to the bottom surface of the IC 100. Fig. 6F also illustrates the bumps 182 attached to the bottom surface of the IC 100. This completes formation of the IC 100.

Note that the processes in method 500 are shown in a particular order for ease of description. However, one or more of the processes may be performed in a different order or may not be performed at all (and thus be optional), in accordance with some embodiments. Numerous variations on method 500 and the techniques described herein will be apparent in light of this disclosure.

### Example System

Fig. 7 illustrates a computing system 1000 implemented with integrated circuit structures and/or the interconnect features formed using the techniques disclosed herein, in accordance with some embodiments of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. As will be appreciated, the motherboard 1002 may be, for example, any printed circuit board, whether a main board, a daughterboard mounted on a main board, or the only board of system 1000, etc.

Depending on its applications, computing system 1000 may include one or more other components that may or may not be physically and electrically coupled to the motherboard 1002. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices formed using the disclosed techniques in accordance with an example embodiment. In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing system 1000 includes an integrated circuit die packaged within the processor 1004. In some embodiments, the integrated circuit die of the processor includes onboard circuitry that is implemented with one or more integrated circuit structures or devices formed using the disclosed techniques, as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more integrated circuit structures or devices formed using the disclosed techniques as variously described herein. As will be appreciated in light of this disclosure, note that multi-standard wireless capability may be integrated directly into the processor 1004 (e.g., where functionality of any chips 1006 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device or system that processes data or employs one or more integrated circuit structures or devices formed using the disclosed techniques, as variously described herein. Note that reference to a computing system is intended to include computing devices, apparatuses, and other structures configured for computing or processing information.

## Claims

1. An integrated circuit device comprising:
a device layer (106) including a plurality of transistors (104, 104a, 104b, 104c, 104d);
a first interconnect structure (110) comprising a first plurality of interconnect features above the device layer (106); and
a second interconnect structure (120) comprising a second plurality of interconnect features below the device layer (106),
wherein the first interconnect structure (110) is used for (i) routing logic signals between transistors (104, 104a, 104b, 104c, 104d) of the plurality of transistors (104, 104a, 104b, 104c, 104d), and for (ii) routing logic signals between transistors (104, 104a, 104b, 104c, 104d) of the plurality of transistors (104, 104a, 104b, 104c, 104d) and first one or more input/output, I/O, pins of the integrated circuit device, and
wherein the second interconnect structure (120) is used for (i) routing logic signals between transistors (104, 104a, 104b, 104c, 104d) of the plurality of transistors (104, 104a, 104b, 104c, 104d), for (ii) routing logic signals between transistors (104, 104a, 104b, 104c, 104d) of the plurality of transistors (104, 104a, 104b, 104c, 104d) and the first one or more I/O pins, and for (iii) routing power from second one or more I/O pins of the integrated circuit device to transistors (104, 104a, 104b, 104c, 104d) of the plurality of transistors (104, 104a, 104b, 104c, 104d).

2. The integrated circuit device of claim 1, wherein:
the first interconnect structure (110) above the device layer (106) is on a frontside of the plurality of transistors (104, 104a, 104b, 104c, 104d) of the device layer (106); and
the second interconnect structure (120) below the device layer (106) is on a backside of the plurality of transistors (104, 104a, 104b, 104c, 104d) of the device layer (106).

3. The integrated circuit device of claim 1 or 2, further comprising:
a third interconnect structure (140) comprising a third plurality of interconnect features below the second interconnect structure (120).

4. The integrated circuit device of claim 3, wherein the third interconnect structure (140) is for (i) routing logic signals between transistors (104, 104a, 104b, 104c, 104d) of the plurality of transistors (104, 104a, 104b, 104c, 104d) and the first one or more I/O pins, and (ii) routing power from the second one or more I/O pins to transistors (104, 104a, 104b, 104c, 104d) of the plurality of transistors (104, 104a, 104b, 104c, 104d).

5. The integrated circuit device of claim 3 or 4, wherein:
interconnect features within an interconnect layer (142) of the third interconnect structure (140) has a first pitch;
interconnect features within an interconnect layer (122) of the second interconnect structure (120) has a second pitch; and
the first pitch is higher than the second pitch by at least 10%.

6. The integrated circuit device of claim 5, wherein the first pitch is higher than the second pitch by at least 25%.

7. The integrated circuit device of claim 5, wherein the first pitch is at least twice the second pitch.

8. The integrated circuit device of any one of claims 3 through 7, wherein for routing a logic signal from a first transistor of the plurality of transistors (104, 104a, 104b, 104c, 104d) to a I/O pin, the logic signal is transmitted (i) from a frontside of the first transistor to first one or more interconnect features of the first interconnect structure (110), (ii) from the first one or more interconnect features of first interconnect structure (110) to second one or more interconnect features of the second interconnect structure (120), through a conductive via extending within the device layer (106), (iii) from the second one or more interconnect features of the second interconnect structure (120) to third one or more interconnect features of the third interconnect structure (140), and (iv) form the third one or more interconnect features of the third interconnect structure (140) to the I/O pin.

9. The integrated circuit device of any one of claims 3 through 8, wherein for routing power from a I/O pin to a first transistor of the plurality of transistors (104, 104a, 104b, 104c, 104d), the power is transmitted (i) from the I/O pin to first one or more interconnect features of the third interconnect structure (140), (ii) from the first one or more interconnect features of the third interconnect structure (140) to second one or more interconnect features of the second interconnect structure (120), and (iii) from the second one or more interconnect features of the second interconnect structure (120) to the transistor (104, 104a, 104b, 104c, 104d), through a conductive via extending within the device layer (106).

10. The integrated circuit device of any one of claims 1 through 9, wherein for routing a logic signal from a first transistor to a second transistor of the plurality of transistors (104, 104a, 104b, 104c, 104d), the logic signal is transmitted (i) from a frontside of the first transistor to first one or more interconnect features of the first interconnect structure (110), (ii) from the first one or more interconnect features of first interconnect structure (110) to second one or more interconnect features of the second interconnect structure (120), through a first conductive via extending within the device layer (106), (iii) from the second one or more interconnect features of the second interconnect structure (120) to third one or more interconnect features of the first interconnect structure (110), through a second conductive via extending within the device layer (106), and (iv) form the third one or more interconnect features of the first interconnect structure (110) to a frontside of the second transistor.

11. The integrated circuit device of any one of claims 1 through 10, further comprising:
a plurality of conductive vias vertically extending within the device layer (106), at least one of the plurality of conductive vias coupling a corresponding one of the first plurality of interconnect features of the first interconnect structure (110) to a corresponding one of the second plurality of interconnect features of the second interconnect structure (120),
wherein the plurality of conductive vias is for (i) routing logic signals between transistors (104, 104a, 104b, 104c, 104d) of the plurality of transistors (104, 104a, 104b, 104c, 104d), (ii) routing logic signals between transistors (104, 104a, 104b, 104c, 104d) of the plurality of transistors (104, 104a, 104b, 104c, 104d) and the first one or more I/O pins, and (iii) routing power from the second one or more I/O pins to transistors (104, 104a, 104b, 104c, 104d) of the plurality of transistors (104, 104a, 104b, 104c, 104d).

12. The integrated circuit structure of claim 11, wherein a conductive via of the plurality of conductive vias is a through silicon via, TSV.

13. The integrated circuit device of any one of claims 1 through 12, further comprising:
a third interconnect structure (140) comprising a third plurality of interconnect features below the second interconnect structure (120),
wherein the first and second one or more I/O pins are conductively coupled to the third interconnect structure (140).

14. The integrated circuit device of any one of claims 1 through 13, wherein one or more transistors (104, 104a, 104b, 104c, 104d) of the plurality of transistors (104, 104a, 104b, 104c, 104d) are nanoribbon or nanosheet transistors, and include wrap around gate structures.

## Patentansprüche

1. Integrierte Schaltungsanordnung, die Folgendes umfasst:
eine Bauelementeschicht (106), die eine Mehrzahl von Transistoren (104, 104a, 104b, 104c, 104d) enthält;
eine erste Interconnect-Struktur (110), die eine erste Mehrzahl von Interconnect-Merkmalen oberhalb der Bauelementeschicht (106) umfasst; und
eine zweite Interconnect-Struktur (120), die eine zweite Mehrzahl von Interconnect-Merkmalen unterhalb der Bauelementeschicht (106) umfasst,
wobei die erste Interconnect-Struktur (110) dazu dient, (i) Logiksignale zwischen den Transistoren (104, 104a, 104b, 104c, 104d) der Mehrzahl von Transistoren (104, 104a, 104b, 104c, 104d), und (ii) Logiksignale zwischen den Transistoren (104, 104a, 104b, 104c, 104d) der Mehrzahl von Transistoren (104, 104a, 104b, 104c, 104d) und dem ersten des einen oder der mehreren Eingabe/Ausgabe-(E/A)-Pins der integrierten Schaltungsanordnung zu routen, und
wobei die zweite Interconnect-Struktur (120) dazu dient, (i) Logiksignale zwischen den Transistoren (104, 104a, 104b, 104c, 104d) der Mehrzahl von Transistoren (104, 104a, 104b, 104c, 104d), (ii) Logiksignale zwischen den Transistoren (104, 104a, 104b, 104c, 104d) der Mehrzahl von Transistoren (104, 104a, 104b, 104c, 104d) und dem ersten des einen oder der mehreren E/A-Pins zu routen, und (iii) Energie von dem zweiten des einen oder der mehreren E/A-Pins der integrierten Schaltungsanordnung zu den Transistoren (104, 104a, 104b, 104c, 104d) der Mehrzahl von Transistoren (104, 104a, 104b, 104c, 104d) zu routen.

2. Integrierte Schaltungsanordnung nach Anspruch 1, wobei:
die erste Interconnect-Struktur (110) oberhalb der Bauelementeschicht (106) sich auf einer Vorderseite der Mehrzahl von Transistoren (104, 104a, 104b, 104c, 104d) der Bauelementeschicht (106) befindet; und
die zweite Interconnect-Struktur (120) unterhalb der Bauelementeschicht (106) sich auf einer Rückseite der Mehrzahl von Transistoren (104, 104a, 104b, 104c, 104d) der Bauelementeschicht (106) befindet.

3. Integrierte Schaltungsanordnung nach Anspruch 1 oder 2, die ferner Folgendes umfasst:
eine dritte Interconnect-Struktur (140), die eine dritte Mehrzahl von Interconnect-Merkmalen unterhalb der zweiten Interconnect-Struktur (120) umfasst.

4. Integrierte Schaltungsanordnung nach Anspruch 3, wobei die dritte Interconnect-Struktur (140) dazu dient, (i) Logiksignale zwischen Transistoren (104, 104a, 104b, 104c, 104d) der Mehrzahl von Transistoren (104, 104a, 104b, 104c, 104d) und dem ersten des einen oder der mehreren E/A-Pins sowie (ii) Energie vom zweiten des einen oder der mehreren E/A-Pins zu den Transistoren (104, 104a, 104b, 104c, 104d) der Mehrzahl von Transistoren (104, 104a, 104b, 104c, 104d) zu routen.

5. Integrierte Schaltungsanordnung nach Anspruch 3 oder 4, wobei:
Interconnect-Merkmale innerhalb einer Interconnect-Schicht (142) der dritten Interconnect-Struktur (140) ein erstes Rastermaß aufweisen;
Interconnect-Merkmale innerhalb einer Interconnect-Schicht (122) der zweiten Interconnect-Struktur (120) ein zweites Rastermaß aufweisen; und
das erste Rastermaß um mindestens 10 % höher als das zweite Rastermaß ist.

6. Integrierte Schaltungsanordnung nach Anspruch 5, wobei das erste Rastermaß um mindestens 25 % höher als das zweite Rastermaß ist.

7. Integrierte Schaltungsanordnung nach Anspruch 5, wobei das erste Rastermaß mindestens doppelt so groß ist wie das zweite Rastermaß.

8. Integrierte Schaltungsanordnung nach einem der Ansprüche 3 bis 7, wobei zum Routen eines Logiksignals von einem ersten Transistor der Mehrzahl von Transistoren (104, 104a, 104b, 104c, 104d) zu einem E/A-Pin, das Logiksignal (i) von einer Vorderseite des ersten Transistors zu dem ersten des einen oder der mehreren Interconnect-Merkmale der ersten Interconnect-Struktur (110), (ii) von dem ersten des einen oder der mehreren Interconnect-Merkmale der ersten Interconnect-Struktur (110) zu einem zweiten des einen oder der mehreren Interconnect-Merkmale der zweiten Interconnect-Struktur (120) durch eine leitfähige Durchkontaktierung, die sich innerhalb der Bauelementschicht (106) erstreckt, (iii) von dem zweiten des einen oder der mehreren Interconnect-Merkmale der zweiten Interconnect-Struktur (120) zu dem dritten des einen oder der mehreren Interconnect-Merkmale der dritten Interconnect-Struktur (140), und (iv) von dem dritten des einen oder der mehreren Interconnect-Merkmale der dritten Interconnect-Struktur (140) zu dem E/A-Pin übertragen wird.

9. Integrierte Schaltungsanordnung nach einem der Ansprüche 3 bis 8, wobei zum Routen von Energie von einem E/A-Pin zu einem ersten Transistor der Mehrzahl von Transistoren (104, 104a, 104b, 104c, 104d) die Energie (i) vom E/A-Pin zu dem ersten des einen oder der mehreren Interconnect-Merkmale der dritten Interconnect-Struktur (140), (ii) von dem ersten des einen oder der mehreren Interconnect-Merkmale der dritten Interconnect-Struktur (140) zu dem zweiten des einen oder der mehreren Interconnect-Merkmale der zweiten Interconnect-Struktur (120), und (iii) von dem zweiten des einen oder der mehreren Interconnect-Merkmale der zweiten Interconnect-Struktur (120) zu dem Transistor (104, 104a, 104b, 104c, 104d) über eine leitfähige Durchkontaktierung, die sich innerhalb der Bauelementeschicht (106) erstreckt, übertragen wird.

10. Integrierte Schaltungsanordnung nach einem der Ansprüche 1 bis 9, wobei zum Routen eines Logiksignals von einem ersten Transistor zu einem zweiten Transistor der Mehrzahl von Transistoren (104, 104a, 104b, 104c, 104d) das Logiksignal (i) von einer Vorderseite des ersten Transistors zu einem ersten des einen oder der mehreren Interconnect-Merkmale der ersten Interconnect-Struktur (110), (ii) von dem ersten des einen oder der mehreren Interconnect-Merkmale der ersten Interconnect-Struktur (110) zu dem zweiten des einen oder der mehreren Interconnect-Merkmale der zweiten Interconnect-Struktur (120) durch eine erste leitfähige Durchkontaktierung, die sich innerhalb der Bauelementeschicht (106) erstreckt, (iii) von dem zweiten des einen oder der mehreren Interconnect-Merkmale der zweiten Interconnect-Struktur (120) zu dem dritten des einen oder der mehreren Interconnect-Merkmale der ersten Interconnect-Struktur (110) durch eine zweite leitfähige Durchkontaktierung, die sich innerhalb der Bauelementeschicht (106) erstreckt, und (iv) von dem dritten des einen oder der mehreren Interconnect-Merkmale der ersten Interconnect-Struktur (110) zu einer Vorderseite des zweiten Transistors übertragen wird.

11. Integrierte Schaltungsanordnung nach einem der Ansprüche 1 bis 10, die ferner Folgendes umfasst:
eine Mehrzahl von leitfähigen Durchkontaktierungen, die sich vertikal innerhalb der Bauelementeschicht (106) erstrecken, wobei mindestens eine der Mehrzahl von leitfähigen Durchkontaktierungen ein entsprechendes der ersten Mehrzahl von Interconnect-Merkmalen der ersten Interconnect-Struktur (110) mit einem entsprechenden der zweiten Mehrzahl von Interconnect-Merkmalen der zweiten Interconnect-Struktur (120) koppelt,
wobei die Mehrzahl von leitfähigen Durchkontaktierungen dazu dient, (i) Logiksignale zwischen den Transistoren (104, 104a, 104b, 104c, 104d) der Mehrzahl von Transistoren (104, 104a, 104b, 104c, 104d), (ii) Logiksignale zwischen den Transistoren (104, 104a, 104b, 104c, 104d) der Mehrzahl von Transistoren (104, 104a, 104b, 104c, 104d) und dem ersten des einen oder der mehreren E/A-Pins, und (iii) Energie von dem ersten des einen oder der mehreren E/A-Pins zu den Transistoren (104, 104a, 104b, 104c, 104d) der Mehrzahl von Transistoren (104, 104a, 104b, 104c, 104d) zu routen.

12. Integrierte Schaltungsstruktur nach Anspruch 11, wobei eine leitfähige Durchkontaktierung der Mehrzahl von leitfähigen Durchkontaktierungen eine Silizium-Durchkontaktierung (TSV) ist.

13. Integrierte Schaltungsanordnung nach einem der Ansprüche 1 bis 12, die ferner Folgendes umfasst:
eine dritte Interconnect-Struktur (140), die eine dritte Mehrzahl von Interconnect-Merkmalen unterhalb der zweiten Interconnect-Struktur (120) umfasst,
wobei der erste und der zweite des einen oder der mehreren E/A-Pins leitend mit der dritten Interconnect-Struktur (140) gekoppelt sind.

14. Integrierte Schaltungsanordnung nach einem der Ansprüche 1 bis 13, wobei ein oder mehrere Transistoren (104, 104a, 104b, 104c, 104d) der Mehrzahl von Transistoren (104, 104a, 104b, 104c, 104d) Nanoband- oder Nanoblatt-Transistoren sind und Wrap-around-Gate-Strukturen einschließen.

## Revendications

1. Dispositif à circuit intégré comprenant :
une couche de dispositif (106) incluant une pluralité de transistors (104, 104a, 104b, 104c, 104d) ;
une première structure d'interconnexion (110) comprenant une première pluralité d'éléments d'interconnexion au-dessus de la couche de dispositif (106) ; et
une deuxième structure d'interconnexion (120) comprenant une deuxième pluralité d'éléments d'interconnexion sous la couche de dispositif (106),
où la première structure d'interconnexion (110) est utilisée pour (i) acheminer des signaux logiques entre des transistors (104, 104a, 104b, 104c, 104d) de la pluralité de transistors (104, 104a, 104b, 104c, 104d), et pour (ii) acheminer des signaux logiques entre des transistors (104, 104a, 104b, 104c, 104d) de la pluralité de transistors (104, 104a, 104b, 104c, 104d) et les premières une ou plusieurs broches d'entrée/sortie, E/S, du dispositif de circuit intégré, et
où la deuxième structure d'interconnexion (120) est utilisée pour (i) acheminer des signaux logiques entre des transistors (104, 104a, 104b, 104c, 104d) de la pluralité de transistors (104, 104a, 104b, 104c, 104d), pour (ii) acheminer des signaux logiques entre des transistors (104, 104a, 104b, 104c, 104d) de la pluralité de transistors (104, 104a, 104b, 104c, 104d) et les premières une ou plusieurs broches d'E/S, et pour (iii) acheminer de la puissance des deuxièmes une ou plusieurs broches d'E/S du dispositif de circuit intégré vers des transistors (104, 104a, 104b, 104c, 104d) de la pluralité de transistors 104 (104, 104a, 104b, 104d).

2. Dispositif à circuit intégré selon la revendication 1, dans lequel :
la première structure d'interconnexion (110) au-dessus de la couche de dispositif (106) se trouve sur un côté avant de la pluralité de transistors (104, 104a, 104b, 104c, 104d) de la couche de dispositif (106) ; et
la deuxième structure d'interconnexion (120) sous la couche de dispositif (106) se trouve sur un côté arrière de la pluralité de transistors (104, 104a, 104b, 104c, 104d) de la couche de dispositif (106).

3. Dispositif de circuit intégré selon la revendication 1 ou la revendication 2 comprenant en outre :
une troisième structure d'interconnexion (140) comprenant une troisième pluralité d'éléments d'interconnexion sous la deuxième structure d'interconnexion (120).

4. Dispositif de circuit intégré selon la revendication 3, dans lequel la troisième structure d'interconnexion (140) est destinée à (i) acheminer des signaux logiques entre des transistors (104, 104a, 104b, 104c, 104d) de la pluralité de transistors (104, 104a, 104b, 104c, 104d) et les premières un ou plusieurs broches d'E/S, et (ii) acheminer de la puissance depuis les deuxièmes une ou plusieurs broches d'E/S vers des transistors (104, 104a, 104b, 104c, 104d) de la pluralité de transistors (104, 104a, 104b, 104c, 104d).

5. Dispositif à circuit intégré selon la revendication 3 ou la revendication 4, dans lequel :
des éléments d'interconnexion dans une couche d'interconnexion (142) de la troisième structure d'interconnexion (140) ont un premier pas ;
des éléments d'interconnexion dans une couche d'interconnexion (122) de la deuxième structure d'interconnexion (120) ont un deuxième pas ; et
le premier pas est supérieur d'au moins 10 % au deuxième pas.

6. Dispositif de circuit intégré selon la revendication 5, dans lequel le premier pas est supérieur au deuxième pas d'au moins 25 %.

7. Dispositif à circuit intégré selon la revendication 5, dans lequel le premier pas est au moins deux fois le deuxième pas.

8. Dispositif à circuit intégré selon l'une quelconque des revendications 3 à 7, dans lequel, pour acheminer un signal logique depuis un premier transistor de la pluralité de transistors (104, 104a, 104b, 104c, 104d) vers une broche d'E/S, le signal logique est transmis (i) d'un côté avant du premier transistor vers des premiers un ou plusieurs éléments d'interconnexion de la première structure d'interconnexion (110), (ii) des premiers un ou plusieurs éléments d'interconnexion d'une première structure d'interconnexion (110) aux deuxièmes un ou plusieurs éléments d'interconnexion de la deuxième structure d'interconnexion (120), à travers un trou d'interconnexion conducteur s'étendant à l'intérieur de la couche de dispositif (106), (iii) des deuxièmes un ou plusieurs éléments d'interconnexion de la deuxième structure d'interconnexion (120) aux troisièmes un ou plusieurs éléments d'interconnexion de la troisième structure d'interconnexion (140), et (iv) des troisièmes un ou plusieurs éléments d'interconnexion de la troisième structure d'interconnexion (140) à la broche d'entrée/sortie, E/S.

9. Dispositif à circuit intégré selon l'une quelconque des revendications 3 à 8, dans lequel, pour acheminer de l'énergie d'une broche d'E/S vers un premier transistor de la pluralité de transistors (104, 104a, 104b, 104c, 104d), l'énergie est transmise (i) de la broche d'E/S à des premiers un ou plusieurs éléments d'interconnexion de la troisième structure d'interconnexion (140), (ii) des premiers un ou plusieurs éléments d'interconnexion de la troisième structure d'interconnexion (140) aux deuxièmes un ou plusieurs éléments d'interconnexion de la deuxième structure d'interconnexion (120), et (iii) des deuxièmes un ou plusieurs éléments d'interconnexion de la deuxième structure d'interconnexion (120) au transistor (104, 104a, 104b, 104c, 104d), à travers un trou d'interconnexion conducteur s'étendant à l'intérieur de la couche de dispositif (106).

10. Dispositif à circuit intégré selon l'une quelconque des revendications 1 à 9, dans lequel, pour acheminer un signal logique depuis un premier transistor vers un deuxième transistor de la pluralité de transistors (104, 104a, 104b, 104c, 104d), le signal logique est transmis (i) d'un côté avant du premier transistor vers des premiers un ou plusieurs éléments d'interconnexion de la première structure d'interconnexion (110), (ii) des premiers un ou plusieurs éléments d'interconnexion d'une première structure d'interconnexion (110) aux deuxièmes un ou plusieurs éléments d'interconnexion de la deuxième structure d'interconnexion (120), à travers un premier trou d'interconnexion conducteur s'étendant à l'intérieur de la couche de dispositif (106), (iii) des deuxièmes un ou plusieurs éléments d'interconnexion de la deuxième structure d'interconnexion (120) aux troisièmes un ou plusieurs éléments d'interconnexion de la première structure d'interconnexion (110), à travers un deuxième trou d'interconnexion conducteur s'étendant à l'intérieur de la couche de dispositif (106), (iv) des troisièmes un ou plusieurs éléments d'interconnexion de la première structure d'interconnexion (110) vers une face avant du deuxième transistor.

11. Dispositif à circuit intégré selon l'une quelconque des revendications 1 à 10, comprenant en outre :
une pluralité de trous d'interconnexion conducteurs s'étendant verticalement à l'intérieur de la couche de dispositif (106), au moins un trou de la pluralité de trous d'interconnexion conducteurs couplant un trou correspondant de la première pluralité d'éléments d'interconnexion de la première structure d'interconnexion (110) à un trou correspondant de la deuxième pluralité d'éléments d'interconnexion de la deuxième structure d'interconnexion (120),
où la pluralité de trous d'interconnexion conducteurs sont destinés à (i) acheminer des signaux logiques entre des transistors (104, 104a, 104b, 104c, 104d) de la pluralité de transistors (104, 104a, 104b, 104c, 104d), (ii) acheminer des signaux logiques entre des transistors (104, 104a, 104b, 104c, 104d) de la pluralité de transistors (104, 104a, 104b, 104 104c, 104d) et les premières une ou plusieurs broches d'E/S, et (iii) acheminer de la puissance des deuxièmes une ou plusieurs broches d'E/S vers des transistors (104, 104a, 104b, 104c, 104d) de la pluralité de transistors (104, 104a, 104b, 104d).

12. Structure de circuit intégré selon la revendication 11, dans laquelle un trou d'interconnexion conducteur de la pluralité de trous d'interconnexion conducteurs est un trou d'interconnexion en silicium traversant, TSV.

13. Dispositif à circuit intégré selon l'une quelconque des revendications 1 à 12, comprenant en outre :
une troisième structure d'interconnexion (140) comprenant une troisième pluralité d'éléments d'interconnexion sous la deuxième structure d'interconnexion (120),
où les premières et deuxièmes une ou plusieurs broches d'E/S sont couplées de manière conductrice à la troisième structure d'interconnexion (140).

14. Dispositif à circuit intégré selon l'une quelconque des revendications 1 à 13, dans lequel les un ou plusieurs transistors (104, 104a, 104b, 104c, 104d) de la pluralité de transistors (104, 104a, 104b, 104c, 104d) sont des transistors à nanorubans ou à nanofeuillets, et comprennent des structures de grille enveloppante.
